# EUROPÄISCHE PATENTSCHRIFT

(11) **EP 1 920 469 B1**
(45) Veröffentlichungstag und Bekanntmachung des Hinweises auf die Patenterteilung: **27.04.2011**
(21) Anmeldenummer: 06775805.2
(22) Anmeldetag: 04.08.2006
(51) Int. Cl.: H01L 33/00

(54) **VERFAHREN ZUM LATERALEN ZERTRENNEN EINES HALBLEITERWAFERS UND OPTOELEKTRONISCHES BAUELEMENT**
METHOD FOR LATERALLY CUTTING THROUGH A SEMICONDUCTOR WAFER AND OPTOELECTRONIC COMPONENT
PROCEDE POUR SEPARER LATERALEMENT UNE PLAQUETTE A SEMI-CONDUCTEURS ET ELEMENT OPTOELECTRONIQUE

(30) Priorität: 01.09.2005 DE 102005041571; 02.11.2005 DE 102005052358
(43) Veröffentlichungstag der Anmeldung: 14.05.2008
(73) Patentinhaber: OSRAM Opto Semiconductors GmbH, 93055 Regensburg (DE)
(72) Erfinder: HÄRLE, Volker, 93164 Laaber (DE); EICHLER, Christoph, 93105 Tegernheim (DE)
(74) Vertreter: Epping - Hermann - Fischer
(86) Internationale Anmeldenummer: PCT/DE2006/001366
(87) Internationale Veröffentlichungsnummer: WO 2007/025497

(56) Entgegenhaltungen:
- DE-A1- 19 959 182
- DE-A1-102004 062 290
- JP-A- 2002 175 985
- US-A1- 2002 068 201
- US-A1- 2005 048 739

## Beschreibung

Diese Patentanmeldung beansprucht die Priorität der deutschen Patentanmeldungen 10 2005 052 358.7 und 10 2005 041 571.7.

Die Erfindung betrifft ein Verfahren zum lateralen Zertrennen eines Halbleiterwafers, insbesondere eines optoelektronischen Halbleiterwafers, bei dem ein Aufwachssubstrat von dem Halbleiterwafer abgetrennt wird, und ein optoelektronisches Bauelement.

Bei der Herstellung optoelektronischer Bauelemente, beispielsweise LEDs oder Halbleiterlasern, ist es oftmals wünschenswert, ein für das epitaktische Aufwachsen einer Halbleiterschichtenfolge des optoelektronischen Bauelements verwendetes Aufwachssubstrat nachträglich von dem Halbleiterwafer abzutrennen.

Beispielsweise wird bei der sogenannten Dünnfilm-Technologie zunächst die Halbleiterschichtenfolge eines optoelektronischen Bauelements epitaktisch auf einem Aufwachssubstrat aufgewachsen, anschließend ein Träger auf die dem Aufwachssubstrat gegenüberliegende Oberfläche der Halbleiterschichtenfolge aufgebracht und nachfolgend das Aufwachssubstrat abgetrennt. Dieses Verfahren hat einerseits den Vorteil, dass auf dem neuen Träger eine vergleichsweise dünne Epitaxieschichtenfolge verbleibt, aus der die von dem optoelektronischen Bauelement emittierte Strahlung mit hoher Effizienz ausgekoppelt werden kann, insbesondere wenn zwischen der Epitaxieschichtenfolge und dem neuen Träger eine reflektierende oder reflexionserhöhende Schicht vorgesehen ist. Weiterhin kann das Aufwachssubstrat nach dem Ablösen vorteilhaft wieder verwendet werden. Dies ist insbesondere dann von Vorteil, wenn das Aufwachssubstrat aus einem vergleichsweise hochwertigem Material, insbesondere Saphir, SiC, GaN oder AlN, besteht.

Ein Verfahren zum lateralen Zertrennen eines Halbleiterwafers wird zum Beispiel in der Druckschrift US 5,374,564 beschrieben.

Weiterhin ist aus der US 6,815,309 ein Verfahren zum lateralen Zertrennen eines Halbleiterwafers bekannt, bei dem eine dünne Schicht eines Epitaxiesubstrats auf ein anderes, geringwertigeres Substrat übertragen wird, um auf diese Weise ein für die Epitaxie geeignetes Quasisubstrat zu erzeugen. Das Epitaxiesubstrat wird dabei durch wiederholtes Ablösen dünner Schichten, die jeweils auf neue Trägersubstrate aufgebracht werden, nach und nach verbraucht. Bei einem derartigen Verfahren besteht die Gefahr, dass die auf das neue Trägersubstrat aufgebrachte dünne Schicht des Epitaxiesubstrats möglicherweise durch die zuvor erfolgte Ionenimplantation, die durch die abzulösende Schicht des Substrats erfolgt, geschädigt wird. Dieses könnte sich beim Aufwachsen epitaktischer Schichten auf das Quasisubstrat möglicherweise nachteilig auf die Kristallqualität der epitaktischen Schichten auswirken.

Aus der Druckschrift C.H. Yun, N.W. Cheung: Thermal and Mechanical Separation of Silicon Layers from Hydrogen Pattern-Implanted Wafers, Journ. of Electronic Materials, Vol. 30, Nr. 8, 2001, S. 960-964, ist ein Verfahren zum thermischen oder mechanischen Abtrennen einer Siliziumschicht von einem Siliziumwafer bekannt.

Weitere Verfahren zum Lateralen Zertrennen eines Hulbleiterwafers sind aus JP-A-2002 175 985 und aus DE-A-199 59 182 bekannt.

Der Erfindung liegt die Aufgabe zugrunde, ein verbessertes Verfahren zum Abtrennen eines Aufwachssubstrats von einem Halbleiterwafer und ein optoelektronisches Bauelement mit einer auf einem Aufwachsubstrat aufgewachsenen Halbleiterschichtenfolge anzugeben, bei dem die Gefahr einer Schädigung des Aufwachssubstrats durch eine Ionenimplantation, die vor dem epitaktischen Aufwachsen von Halbleiterschichten erfolgt, vermindert ist. Weiterhin soll das Aufwachssubstrat vorzugsweise restlos von dem Halbleiterwafer abgelöst werden und somit vollständig wieder verwertbar sein.

Diese Aufgabe wird durch ein Verfahren mit den Merkmalen des Patentanspruchs 1 gelöst. Vorteilhafte Ausgestaltungen und Weiterbildungen der Erfindung sind Gegenstand der abhängigen Ansprüche.

Bei einem Verfahren zum lateralen Zertrennen eines Halbleiterwafers gemäß der Erfindung wird ein Aufwachssubstrat bereitgestellt, auf das eine Halbleiterschichtenfolge epitaktisch aufgewachsen wird, wobei die Halbleiterschichtenfolge eine als Trennschicht vorgesehene Schicht und mindestens eine der Trennschicht in Wachstumsrichtung nachfolgende funktionelle Halbleiterschicht umfasst. Nachfolgend werden Ionen durch die funktionelle Halbleiterschicht hindurch in die Trennschicht implantiert und der Halbleiterwafer zertrennt, wobei ein das Aufwachssubstrat enthaltender Teil des Halbleiterwafers entlang der Trennschicht abgetrennt wird.

Dadurch, dass die Ionenimplantation nicht in das Aufwachssubstrat, sondern in eine Trennschicht, die in der epitaktisch aufgewachsenen Halbleiterschichtenfolge enthalten ist, erfolgt, wird beim Zertrennen des Halbleiterwafers entlang der Trennschicht ein Teil des Halbleiterwafers abgetrennt, der das gesamte Aufwachssubstrat enthält. Der Halbleiterwafer wird in einer lateralen Richtung, die in einer Ebene der Trennschicht verläuft, zertrennt. Das. Aufwachssubstrat wird beim Zertrennen des Halbleiterwafers also vorteilhaft nicht durchtrennt und kann vollständig wieder verwendet werden. Insbesondere kann mehrfach eine Schichtenfolge auf dem Aufwachssubstrat aufgewachsen und nachfolgend abgetrennt werden, ohne dass dabei das Aufwachssubstrat sukzessiv verbraucht wird. Dies ist insbesondere dann vorteilhaft, wenn ein hochwertiges Substrat als Aufwachssubstrat verwendet wird, wie zum Beispiel ein GaN-Substrat, ein AlN-Substrat, ein Saphir-Substrat oder ein SiC-Substrat.

Das Zertrennen erfolgt vorzugsweise mittels einer Temperaturbehandlung, bevorzugt bei einer Temperatur im Bereich von 300°C bis 1200 °C. Insbesondere kann die Temperaturbehandlung bei einer Temperatur zwischen 300 °C und 900 °C erfolgen. Dabei diffundieren die implantierten Ionen in der Trennschicht und erzeugen Bläschen (Blister). Die Ausbreitung der Bläschen in der Trennschicht führt schließlich zum Zertrennen des Halbleiterwafers in einen ersten Teil, der das Aufwachssubstrat enthält, und einen zweiten Teil, der die funktionelle Halbleiterschicht enthält.

Auf diese Weise wird ein das Aufwachssubstrat enthaltender Teil des Halbleiterwafers abgetrennt.

Bei der Temperaturbehandlung kann das Aufheizen der Trennschicht sowohl durch eine Erhöhung der Umgebungstemperatur als auch durch eine lokale Erwärmung durch elektromagnetische Strahlung, zum Beispiel Laser- oder Mikrowellenstrahlung, bewirkt werden.

Alternativ kann der Halbleiterwafer entlang der Implantationsbereiche auch auf mechanische Weise zertrennt werden, beispielsweise indem die gegenüberliegen Oberflächen des Halbleiterwafers mit Hilfsträgern verbunden werden und auf diese ein Drehmoment ausgeübt wird, so dass der Halbleiterwafer entlang der Trennschicht zertrennt wird.

Nach dem Verfahrensschritt des Zertrennens des Halbleiterwafers zum Abtrennen des Aufwachsubstrats kann das Aufwachssubstrat einen abgetrennten Teil der Trennschicht enthalten. Dieser nach dem Abtrennen auf dem Aufwachssubstrat enthaltene Teil der Trennschicht wird vorzugsweise nachträglich vom Aufwachssubstrat entfernt, beispielsweise mittels eines Ätz- oder Polierprozesses, um das Aufwachssubstrat für das epitaktische Aufwachsen weiterer Halbleiterschichtenfolgen vorzubereiten.

Die Halbleiterschichtenfolge basiert vorzugsweise auf einem Nitridverbindungshalbleitermaterial. "Auf einem Nitridverbindungshalbleitermaterial basierend" bedeutet im folgenden, dass ein derart bezeichnetes Bauelement oder Teil eines Bauelements vorzugsweise InₓAl_{y}Ga_{1-x-y}N umfasst, wobei 0 ≤ × ≤ 1, 0 ≤ y ≤ 1 und ×+y ≤ 1 gilt. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Bevorzugt werden Wasserstoffionen durch die funktionelle Halbleiterschicht hindurch in die Trennschicht implantiert. Alternativ können auch Ionen von Edelgasen wie beispielsweise Helium, Neon, Krypton oder Xenon verwendet werden.

Es ist auch möglich, dass Ionen verschiedener Atome implantiert werden, insbesondere Wasserstoffionen und Heliumionen oder Wasserstoffionen und Borionen. Dies hat den Vorteil, dass die benötigte Implantationsdosis verringert wird.

Die zum Abtrennen eines Teils des Halbleiterwafers, der das Aufwachssubstrat enthält, durchgeführte Temperaturbehandlung erfolgt vorzugsweise bei einer Temperatur im Bereich von 300 °C bis 900 °C. Dabei diffundieren die implantierten Ionen in der Trennschicht und erzeugen Bläschen (Blister).

Nach der Ionenimplantation erfolgt vorzugsweise ein thermisches Ausheilen der Halbleiterschichtenfolge, um eine mögliche Beeinträchtigung der Schichtqualität, die aufgrund der durch die Halbleiterschichtenfolge erfolgenden Ionenimplantation auftreten könnte, zu vermindern. Das thermische Ausheilen muss nicht unmittelbar nach der Ionenimplantation erfolgen, sondern kann insbesondere auch erst nach dem Zertrennen des Halbleiterwafers erfolgen, wenn beispielsweise die zum Zertrennen des Halbleiterwafers führende Bläschenbildung bereits bei einer geringeren als der für den Ausheilprozess erforderlichen Temperatur einsetzt.

Die Trennschicht enthält vorzugsweise zumindest ein Element, das eine größere Kernladungszahl als Gallium aufweist, zum Beispiel Indium. Das Element mit der größeren Kernladungszahl als Gallium kann als Dotierstoff in die Trennschicht eingebracht sein oder vorzugsweise Bestandteil des Halbleitermaterials der Trennschicht sein. Insbesondere kann die Trennschicht eine InGaN-Schicht sein. Das Vorhandensein eines Elements mit hoher Kernladungszahl in der Trennschicht hat den Vorteil, dass die bei der Ionenimplantation in die Trennschicht eindringenden Ionen abgebremst werden und somit ein weiteres Eindringen vermindert wird. Die Trennschicht wirkt in diesem Fall also als Stoppschicht für die implantierten Ionen.

Dies ist insbesondere dann vorteilhaft, wenn bei der Ionenimplantation vergleichsweise hochenergetische Ionen implantiert werden, um eine mögliche Schädigung der funktionellen Halbleiterschicht zu vermindern. Insbesondere hat sich herausgestellt, dass eine Schädigung der funktionellen Halbleiterschicht durch eine Erhöhung der Ionenenergie bei der Ionenimplantation vermindert werden kann. Eine Erhöhung der Ionenenergie hat allerdings in der Regel zur Folge, dass die implantierten Ionen ein breiteres und flacheres Konzentrationsprofil in einer Richtung senkrecht zur Ebene der Trennschicht ausbilden, das sich nachteilig auf den Ablöseprozess auswirken könnte. Die volle halbwertsbreite des Konzentrationsprofils der implantierten Ionen kann beispielsweise etwa 200 nm betragen.

Dadurch, dass die Trennschicht mindestens ein Element mit einer Kernladungszahl, die größer ist als die von Gallium, enthält, kann auch bei vergleichsweise hoher Ionenenergie der implantierten Ionen ein vergleichsweise schmales Konzentrationsprofil in der Trennschicht erzielt werden, wodurch der Verfahrensschritt des Abtrennens erleichtert wird.

Bei einer weiteren vorteilhaften Ausgestaltung der Erfindung enthält die Halbleiterschichtenfolge mindestens eine der Trennschicht benachbarte Diffusionsbarriereschicht für die implantierten Ionen. Unter einer Diffusionsbarriereschicht wird dabei eine Schicht verstanden, in der die implantierten Ionen einen geringeren Diffusionskoeffizienten aufweisen als in der Trennschicht. Die Diffusionsbarriereschicht kann in der Wachstumsrichtung der Halbleiterschichtenfolge oberhalb und/oder unterhalb der Trennschicht angeordnet sein.

Die Diffusionsbarriereschicht enthält vorteilhaft ein mit Zn, Fe oder Si dotiertes Nitridverbindungshalbleitermaterial und ist bevorzugt nicht p-dotiert. Insbesondere hat sich herausgestellt, dass Wasserstoff in vergleichsweise hochohmigem Zn-dotierten GaN oder mit Si dotiertem n-GaN einen geringeren Diffusionskoeffizienten aufweist als in mit Mg dotiertem p-GaN.

Insbesondere mit einer in Wachstumsrichtung der Schichtenfolge gesehen oberhalb der Trennschicht angeordneten Diffusionsbarriereschicht kann eine Diffusion der implantierten Ionen in die funktionelle Halbleiterschicht vermindert werden. Andernfalls könnte eine Diffusion der implantierten Ionen die Qualität der funktionellen Halbleiterschicht beeinträchtigen.

Besonders bevorzugt ist beidseits der Trennschicht, also in Wachstumsrichtung der Halbleiterschichtenfolge sowohl oberhalb als auch unterhalb der Trennschicht, eine Diffusionsbarriereschicht angeordnet. Durch die Diffusionsbarriereschicht oder die Diffusionsbarriereschichten wird eine Diffusion der implantierten Ionen in einer senkrecht zur Ebene der Trennschicht verlaufenden Richtung vermindert. Auf diese Weise wird einer unerwünschten Verbreiterung des Konzentrationsprofils der implantierten Ionen in einer Richtung senkrecht zur Schichtebene der Trennschicht entgegen gewirkt.

Bei einer weiteren bevorzugten Ausführungsform der Erfindung ist die Trennschicht eine tensil verspannte Schicht. Die Gitterkonstante der Trennschicht ist in diesem Fall geringer als die Gitterkonstante zumindest einer an die Trennschicht angrenzenden Schicht. Dies hat zur Folge, dass die Trennschicht einer Zugspannung ausgesetzt ist. Bevorzugt ist die tensil verspannte Schicht eine Nitridverbindungshalbleiterschicht, die Aluminium enthält. Die tensile Verspannung der Trennschicht kann in diesem Fall beispielsweise dadurch hervorgerufen sein, dass an die Trennschicht eine weitere Nitridverbindungshalbleiterschicht angrenzt, die einen geringeren Aluminiumanteil als die Trennschicht aufweist oder sogar frei von Aluminium ist. Insbesondere kann eine InGaN-Schicht an die Trennschicht angrenzen. Eine tensile Verspannung der Trennschicht kann weiterhin dadurch erzeugt werden, dass die Trennschicht mit Silizium dotiert ist. Durch die tensile Verspannung der Trennschicht wird der Verfahrensschritt des Abtrennens vorteilhaft erleichtert, da die Grenzfläche zwischen der tensil verspannten Trennschicht und der angrenzenden Schicht mit größerer Gitterkonstante in diesem Fall als Sollbruchstelle wirkt.

Weiterhin kann bei der Erfindung der Verfahrensschritt des Abtrennens mit Vorteil dadurch erleichtert werden, dass die Trennschicht eine durch laterales epitaktisches Überwachsen (ELOG, Epitaxial Layer Over Growth) hergestellte Halbleiterschicht ist. In diesem Fall wird die Trennschicht nicht direkt auf dem Aufwachssubstrat oder auf eine bereits auf das Aufwachssubstrat aufgebrachte Halbleiterschicht aufgewachsen, sondern vorher eine Maskenschicht auf das Aufwachssubstrat oder die Halbleiterschicht, auf der die Trennschicht aufgewachsen werden soll, aufgebracht. Die Maskenschicht ist vorzugsweise eine Siliziumnitridschicht, oder eine Siliziumdioxidschicht. Das epitaktische Wachstum der Trennschicht setzt in den nicht von der Maskenschicht bedeckten Bereichen des Aufwachssubstrats oder der zum Aufwachsen vorgesehenen Halbleiterschicht ein, wobei nachfolgend die maskierten Bereiche in lateraler Richtung überwachsen werden. Da die Haftung einer durch laterales epitaktisches Überwachsen hergestellten Trennschicht auf der lateral überwachsenen Maskenschicht nur gering ist, wirken die Grenzflächen zwischen der Maskenschicht und der Trennschicht als Sollbruchstellen bei dem Verfahrensschritt des Abtrennens.

Weiterhin ist es vorteilhaft, wenn die Trennschicht aus einem Halbleitermaterial gebildet ist, in dem die implantierten Ionen einen größeren Diffusionskoeffizienten als in einer an die Trennschicht angrenzenden Schicht aufweisen. Dadurch wird die Diffusion der implantierten Ionen innerhalb der Trennschicht, also insbesondere in einer parallel zur Ebene des Halbleiterwafers verlaufenden Richtung, erhöht und somit das Ausbilden von Bläschen in der Trennschicht gefördert, wodurch der Verfahrensschritt des Abtrennens erleichtert wird. Die diffusionsfördernde Trennschicht ist vorzugsweise eine p-dotierte Nitridverbindungshalbleiterschicht, die zum Beispiel mit Mg dotiert sein kann. Insbesondere hat sich herausgestellt, dass Wasserstoff in p-dotiertem GaN einen höheren Diffusionskoeffizienten aufweist als in einer mit Zn dotierten hochohmigen GaN-Schicht oder einer mit Silizium dotierten n-GaN-Schicht.

Der Halbleiterwafer wird vorzugsweise vor dem Abtrennen des Teils, der das Aufwachssubstrat enthält, an einer von dem Aufwachssubstrat abgewandten Oberfläche mit einem Trägersubstrat verbunden. Das Trägersubstrat vereinfacht die Handhabung der von dem Aufwachssubstrat abgetrennten epitaktischen Schichtenfolge und kann insbesondere als Träger für ein aus der Halbleiterschichtenfolge hergestelltes optoelektronisches Bauelement fungieren.

Das Trägersubstrat kann ein Zwischenträger sein, wobei ein Abtrennen oder Auflösen des Zwischenträgers in einem nachfolgenden Verfahrensschritt vorgesehen ist. Beispielsweise ist der Zwischenträger ein Glassubstrat. Das Glassubstrat wird vorzugsweise mittels einer Zwischenschicht aus einem Siliziumoxid mit der Halbleiterschichtenfolge verbunden. Der Zwischenträger kann in diesem Fall in einem späteren Verfahrensschritt einschließlich der Zwischenschicht zum Beispiel in Flusssäure (HF) aufgelöst werden.

Die funktionelle Halbleiterschicht ist vorzugsweise eine strahlungsemittierende oder strahlungsdetektierende Schicht. Insbesondere kann die funktionelle Halbleiterschicht die aktive Schicht einer Lumineszenzdiode oder eines Halbleiterlasers sein. Besonders bevorzugt weist die funktionelle Halbleiterschicht InₓAl_{y}Ga_{1-x-y}N mit 0 ≤ × ≤ 1, 0 ≤ y ≤ 1 und x + y ≤ 1 auf.

Alternativ kann die Halbleiterschichtenfolge auch auf einem Phosphidverbindungshalbleiter oder einem Arsenidverbindungshalbleiter basieren. In diesem Fall weist die Halbleiterschichtenfolge und insbesondere die funktionelle Halbleiterschicht bevorzugt InₓAl_{y}Ga_{1-x-y}P oder InₓAl_{y}Ga_{1-x-y}As mit 00 ≤ × ≤ 1, 0 ≤ y ≤ 1 und x + y ≤ 1 auf.

Bei einer weiteren bevorzugten Ausführungsform der Erfindung enthält die Halbleiterschichtenfolge eine oder mehrere weitere Trennschichten, welche der Trennschicht in Wachstumsrichtung nachfolgen. Jeder Trennschicht folgt vorzugsweise in Wachstumsrichtung eine funktionelle Halbleiterschicht nach. Auf das Aufwachssubstrat wird also eine Halbleiterschichtenfolge aus mehreren Teilschichtenfolgen aufgebracht, wobei die Teilschichtenfolgen jeweils durch eine Trennschicht voneinander separiert sind.

In diesem Fall erfolgt zunächst eine Ionenimplantation in eine obere Trennschicht, die den größten Abstand vom Aufwachssubstrat aufweist. Vorzugsweise wird anschließend die Halbleiterschichtenfolge an einer von dem Aufwachsubstrat abgewandten Seite mit einem Trägersubstrat verbunden. Nachfolgend wird der Halbleiterwafer, zum Beispiel mit einer Temperaturbehandlung, entlang der oberen Trennschicht zertrennt. Auf diese Weise wird die oberhalb der oberen Trennschicht angeordnete Teilschichtenfolge von dem Halbleiterwafer abgetrennt und auf das Trägersubstrat übertragen. Die zuvor genannten Verfahrensschritte werden entsprechend der Anzahl der Trennschichten wiederholt durchgeführt, um die mehreren Teilschichtenfolgen sukzessiv durch Zertrennen des Halbleiterwafers entlang.der jeweiligen Trennschicht von dem Halbleiterwafer abzutrennen.

Ein Aufwachssubstrat kann so vorteilhaft zum Aufwachsen mehrerer Teilschichtenfolgen mit funktionellen Halbleiterschichten, die mittels Ionenimplantation und einem nachfolgenden Trennprozess nacheinander von dem Halbleiterwafer abgetrennt und jeweils auf ein Trägersubstrat übertragen werden, verwendet werden.

Die Erfindung wird im Folgenden anhand von Ausführungsbeispielen im Zusammenhang mit den Figuren 1 bis 6 näher erläutert.

Es zeigen:
- Figuren 1A, 1B und 1C: schematische Darstellungen eines Querschnitts durch einen Halbleiterwafer bei Zwischenschritten eines Verfahrens gemäß einem ersten Ausführungsbeispiel der Erfindung,
- Figur 2: eine schematische Darstellung eines Querschnitts durch einen Halbleiterwafer bei einem Zwischenschritt eines Verfahrens gemäß einem zweiten Ausführungsbeispiel der Erfindung,
- Figur 3: eine schematische Darstellung eines Querschnitts durch einen Halbleiterwafer bei einem Zwischenschritt eines Verfahrens gemäß einem dritten Ausführungsbeispiel der Erfindung,
- Figur 4: eine schematische Darstellung eines Querschnitts durch einen Halbleiterwafer bei einem Zwischenschritt eines Verfahrens gemäß einem vierten Ausführungsbeispiel der Erfindung,
- Figur 5: eine schematische Darstellung eines Querschnitts durch einen Halbleiterwafer bei einem Zwischenschritt eines Verfahrens gemäß einem fünften Ausführungsbeispiels der Erfindung, und
- Figuren 6A bis 6F: schematische Darstellungen von Querschnitten durch einen Halbleiterwafer bei Zwischenschritten eines Verfahrens gemäß einem sechsten Ausführungsbeispiel der Erfindung.

Gleiche oder gleichwirkende Elemente sind in den Figuren mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

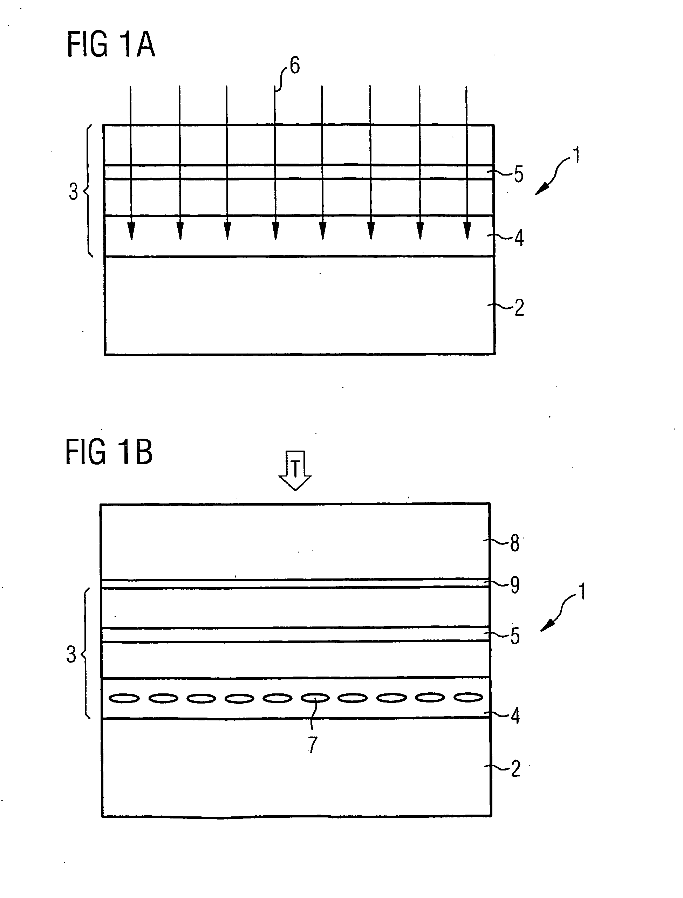

In Figur 1A ist ein Halbleiterwafer 1 schematisch im Querschnitt dargestellt, der ein Aufwachssubstrat 2 und eine epitaktisch auf das Aufwachssubstrat 2 aufgebrachte Halbleiterschichtenfolge 3 umfasst. Die Halbleiterschichtenfolge 3 ist beispielsweise mittels metallorganischer Gasphasenepitaxie (MOVPE) auf das Aufwachssubstrat 2 aufgebracht. Die epitaktische Halbleiterschichtenfolge 3 basiert vorzugsweise auf einem Nitridverbindungshalbleiter.

Das Aufwachssubstrat 2 ist bevorzugt ein zum epitaktischen Aufwachsen eines Nitridverbindungshalbleiters geeignetes Substrat, bei dem es sich insbesondere um ein GaN-Substrat, ein AlN-Substrat, ein SiC-Substrat oder ein Saphir-Substrat handeln kann.

Die epitaktische Halbleiterschichtenfolge 3 enthält mindestens eine funktionelle Halbleiterschicht 5, zum Beispiel eine für ein optoelektronisches Bauelement vorgesehene strahlungsemittierende oder strahlungsdetektierende Schicht.

Insbesondere kann es sich bei der funktionellen Halbleiterschicht 5 um eine Schicht handeln, die als aktive Schicht einer Lumineszenzdiode oder eines Halbleiterlasers vorgesehen ist. Die aktive Schicht kann dabei zum Beispiel als Heterostruktur, Doppelheterostruktur oder Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Weiterhin enthält die epitaktische Halbleiterschichtenfolge 3 eine zwischen dem Aufwachssubstrat 2 und der funktionellen Halbleiterschicht 5 angeordnete Trennschicht 4.

In die Trennschicht 4 werden, wie durch die Pfeile 6 angedeutet wird, durch die funktionelle Halbleiterschicht 5 hindurch Ionen implantiert. Bei den implantierten Ionen kann es sich insbesondere um Wasserstoffionen, oder alternativ um Ionen von Edelgasen wie beispielsweise Helium, Neon, Krypton oder Xenon handeln. Es ist auch möglich, dass Ionen verschiedener Atome implantiert werden, insbesondere Wasserstoffionen und Heliumionen oder Wasserstoffionen und Borionen. Dies hat den Vorteil, dass die benötigte Implantationsdosis verringert wird.

Anschließend wird der Halbleiterwafer 1, wie in Figur 1B dargestellt, an einer dem Aufwachssubstrat 2 gegenüber liegenden Oberfläche mit einem Trägersubstrat 8 verbunden. Das Trägersubstrat 8 wird vorzugsweise mittels Löten oder Bonden mit dem Halbleiterwafer 1 verbunden. Beispielsweise kann das Trägersubstrat 8 mit einer Schicht der Halbleiterschichtenfolge 3 verbunden werden. Alternativ kann die Halbleiterschichtenfolge 3 vor dem Verbinden mit dem Trägersubstrat 8 mit einer Kontaktschicht und/oder reflexionserhöhenden Schicht 9 versehen werden.

Da das Trägersubstrat 8 im Gegensatz zum Aufwachssubstrat 2 nicht zum epitaktischen Aufwachsen der Halbleiterschichtenfolge 3, die zum Beispiel auf einem Nitridverbindungshalbleitermaterial basiert, geeignet sein muss, besteht für das.Trägersubstrat 8 eine vergleichsweise große Freiheit bei der Materialauswahl. Insbesondere kann ein Trägersubstrat 8 ausgewählt werden, das sich durch vergleichsweise geringe Kosten und/oder eine gute Wärmeleitfähigkeit auszeichnet. Beispielsweise kann das Trägersubstrat 8 aus Ge, GaAs, einem Metall wie beispielsweise Mo oder Au, einer Metalllegierung, oder einer Keramik wie zum Beispiel AlN gebildet sein.

Nachfolgend wird, wie in Figur 1B durch den Pfeil T angedeutet, eine Temperaturbehandlung durchgeführt, die eine Diffusion der in die Trennschicht 4 implantierten Ionen bewirkt. Die Temperaturbehandlung erfolgt vorzugsweise bei einer Temperatur zwischen 300 °C und 1200 °C. Die durch die Temperaturbehandlung angeregte Diffusion der implantierten Ionen in der Trennschicht 4 führt zu einer Ausbildung von Bläschen 7 in der Trennschicht 4, deren Größe und Anzahl mit zunehmender Dauer der Temperaturbehandlung zunimmt.

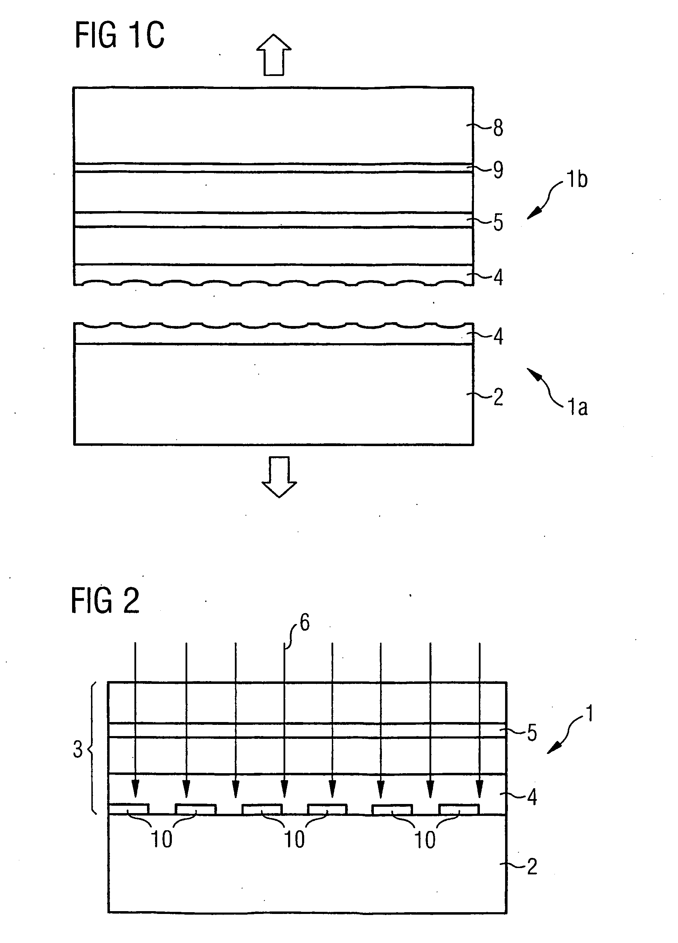

Die durch die Diffusion der implantierten Ionen bewirkte Bildung von Bläschen 7 führt schließlich, wie in Figur 1C schematisch dargestellt ist, zu einem Zertrennen des Halbleiterwafers 1 in einen ersten Teil 1a der das Aufwachssubstrat 2 enthält und einen zweiten Teil 1b, der die funktionelle Halbleiterschicht 5 enthält.

Der von dem Aufwachssubstrat 2 abgetrennte Teil 1b des Halbleiterwafers 1 kann insbesondere ein optoelektronisches Bauelement sein, beispielsweise eine Lumineszenzdiode oder ein Halbleiterlaser, oder zu einem optoelektronischen Bauelement weiterverarbeitet werden. Weiterhin kann der abgetrennte Teil 1b des Halbleiterwafers auch zu einer Mehrzahl optoelektronischer Bauelemente vereinzelt werden.

Nach dem Zertrennen des Halbleiterwafers 1 in zwei Teile 1a, 1b können die auf dem Aufwachssubstrat 2 und/oder auf dem abgetrennten Teil der Halbleiterschichtenfolge 3 verbleibenden Reste der Trennschicht 4 mittels eines Ätz- oder Polierprozesses geglättet oder auch vollständig entfernt werden.

Das Aufwachssubstrat 2, das beispielsweise ein hochwertiges Substrat aus GaN, AlN, SiC oder Saphir ist, kann somit vollständig zum Aufwachsen weiterer Halbleiterschichtenfolgen wieder verwendet werden. Auf diese Weise können insbesondere epitaktische Halbleiterschichtenfolgen für eine Vielzahl von optoelektronischen Bauelementen auf einem einzigen Aufwachssubstrat hergestellt werden. Die Herstellungskosten werden dadurch vorteilhaft vermindert.

Um das in Figur 1C schematisch dargestellte Zertrennen des Halbleiterwafers 1 in zwei Teile 1a, 1b zu vereinfachen, ist es vorteilhaft, wenn das Tiefenprofil der in die Trennschicht 4 implantierten Ionen eine vergleichsweise geringe Halbwertsbreite aufweist. Das Material der Trennschicht 4 wird dazu vorteilhaft derart gewählt, dass es eine Stoppschicht für die implantierten Ionen darstellt. Die Trennschicht 4 enthält zu diesem Zweck vorteilhaft mindestens ein Element, das eine größere Kernladungszahl als Gallium aufweist. Beispielsweise kann die Trennschicht 4 eine Nitridverbindungshalbleiterschicht sein, die Indium enthält. An den in der Trennschicht 4 enthaltenen Atomen des Elements mit hoher Kernladungszahl werden die Ionen bei der Ionenimplantation vergleichsweise stark abgebremst, wodurch ein vorteilhaft schmales Konzentrationsprofil innerhalb der Trennschicht 4 erzeugt wird. Mit einer derartigen als Stoppschicht für die implantierten Ionen fungierenden Trennschicht 4 können die Ionen vorteilhaft mit einer vergleichsweise hohen Ionenenergie durch die funktionelle Halbleiterschicht 5 in die Trennschicht 4 implantiert werden, wobei eine ansonsten auftretende Verbreiterung des Konzentrationsprofils aufgrund der hohen Ionenenergie durch die als Stoppschicht wirkende Trennschicht 4 vermindert wird. Die Verwendung einer hohen Ionenenergie bei der Ionenimplantation ist vorteilhaft, weil in diesem Fall die von dem Halbleiterwafer 1 abzutrennende Halbleiterschichtenfolge 3 weniger geschädigt wird. Ein tiefes Eindringen der implantierten Ionen in die Halbleiterschichtenfolge kann insbesondere unter Ausnutzung der Gitterführung (Channeling) erzielt werden.

Das Zertrennen des Halbleiterwafers 1 kann dadurch vereinfacht werden, dass die Trennschicht 4 als Sollbruchstelle ausgebildet ist. Dies ist so zu verstehen, dass die Trennschicht 4 beispielsweise aufgrund ihrer Struktur oder aufgrund von mechanischen Spannungen mit vergleichsweise geringem Aufwand zu zertrennen oder von den benachbarten Schichten abzutrennen ist. Insbesondere kann die Trennschicht 4 eine tensil verspannte Schicht sein. Dies bedeutet, dass die Trennschicht 4 eine kleinere Gitterkonstante als zumindest eine benachbarte Halbleiterschicht oder das Aufwachssubstrat 2 aufweist.

Insbesondere kann die tensil verspannte Trennschicht eine Nitridverbindungshalbleiterschicht sein, die Aluminium enthält. Der Aluminiumanteil in der tensil verspannten Schicht ist dabei vorteilhaft größer als in mindestens einer an die Trennschicht 4 angrenzenden Halbleiterschicht und/oder in dem Aufwachssubstrat 2. Weiterhin kann eine tensile Verspannung einer auf einem Nitridverbindungshalbleiter basierenden Trennschicht 4 auch durch eine Dotierung der Trennschicht 4 mit Atomen, die eine kleinere Ordnungszahl als Gallium aufweisen, zum Beispiel durch eine Dotierung mit Silizium, erzielt werden.

Bei dem in Figur 2 schematisch dargestellten Zwischenschritt bei einem Ausführungsbeispiel des erfindungsgemäßen Verfahrens ist die Trennschicht 4 eine durch epitaktisches laterales Überwachsen (ELOG) hergestellte Schicht. Zur Herstellung der ELOG-Schicht wird eine Maskenschicht 10 strukturiert auf das Aufwachssubstrat 2 aufgebracht, oder, falls die Trennschicht 4 nicht direkt auf das Aufwachssubstrat 2 aufgebracht ist, auf eine in Wachstumsrichtung unterhalb der Trennschicht 4 angeordnete Halbleiterschicht aufgebracht. Bei der Maskenschicht 10 kann es sich insbesondere um eine Siliziumnitrid- oder Siliziumoxidschicht handeln.

Die als ELOG-Schicht hergestellte Trennschicht 4 vereinfacht das Zertrennen des Halbleiterwafers 1, da das Halbleitermaterial der Trennschicht 4 auf den Bereichen der Maskenschicht 10, die lateral überwachsen werden, eine vergleichsweise geringe Haftung aufweist. Der Halbleiterwafer 1 kann daher in einer Ebene, die entlang einer der Trennschicht 4 zugewandten Oberfläche der Maskenschicht 10 verläuft, mit vergleichsweise geringem Aufwand zertrennt werden.

Anstelle einer ELOG-Maskenschicht 10 kann auch eine in-situ-SiN-Schicht zum Aufwachsen der Trennschicht mittels lateralen Überwachsens verwendet werden. Eine in-situ SiN-Schicht wird als derart dünne Schicht aufgebracht, dass sie noch nicht zu einer kontinuierlichen Schicht zusammengewachsen ist und somit das Aufwachssubstrat nicht vollständig bedeckt. Auf diese Weise fungiert die in-situ-SiN-Schicht als Maskenschicht.

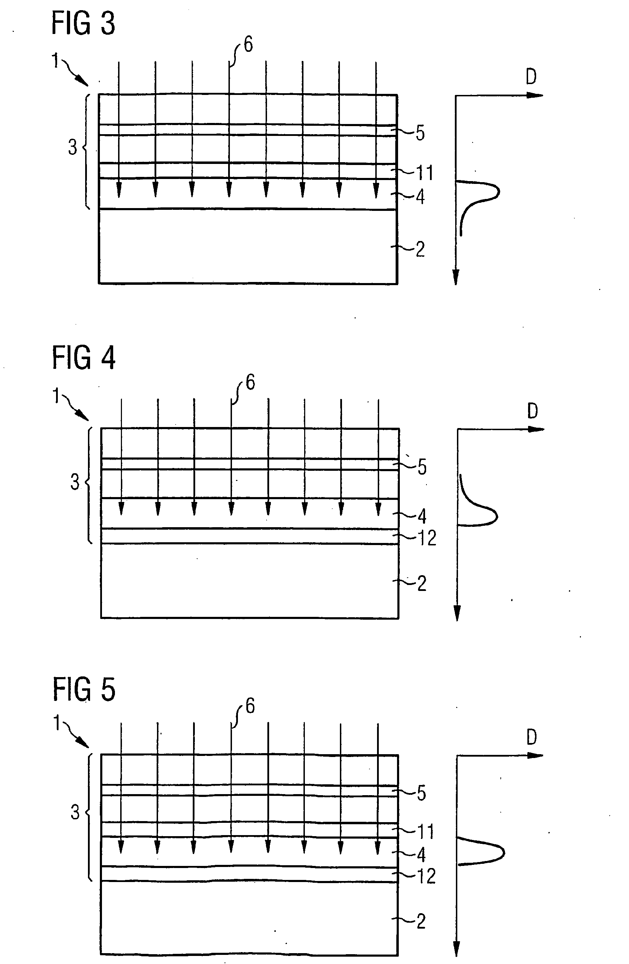

Bei einem weiteren bevorzugten Ausführungsbeispiel ist, wie in Figur 3 schematisch dargestellt, eine Diffusionsbarriereschicht 11 in Wachstumsrichtung der Halbleiterschichtenfolge 3 oberhalb der Trennschicht 4 angeordnet. Die Diffusionsbarriereschicht 11 ist bevorzugt eine undotierte oder eine n-dotierte Nitridverbindungshalbleiterschicht, zum Beispiel eine mit Zn dotierte GaN-Schicht oder eine Si-dotierte n-GaN-Schicht. Insbesondere ist die Diffusionsbarriereschicht 11 nicht p-dotiert.

Die Diffusionsbarriereschicht 11 vermindert vorteilhaft eine Diffusion der in die Trennschicht 4 implantierten Ionen in darüber liegende Halbleiterschichten, insbesondere in die funktionelle Halbleiterschicht 5. Das schematisch dargestellte Tiefenprofil der Konzentration D der implantierten Ionen wird auf diese Weise nach oben hin verschmälert. Einer Schädigung der funktionellen Halbleiterschicht durch diffundierende Ionen wird auf diese Weise vorgebeugt.

Bei dem in Figur 4 dargestellten Ausführungsbeispiel ist eine Diffusionsbarriereschicht 12 im Gegensatz zu dem in Figur 3 dargestellten Ausführungsbeispiel nicht oberhalb, sondern unterhalb der Trennschicht 4 angeordnet. Durch die in Wachstumsrichtung unterhalb der Trennschicht 4 angeordnete Diffusionsbarriereschicht 12 wird vorteilhaft eine Diffusion der implantierten Ionen in das Aufwachssubstrat vermindert und das schematisch dargestellte Tiefenprofil der Konzentration D der implantierten Ionen zum Aufwachssubstrat 2 hin verschmälert.

Besonders bevorzugt sind, wie in Figur 5 dargestellt, sowohl unterhalb als auch oberhalb der Trennschicht 4 Diffusionsbarriereschichten 11, 12 angeordnet. In diesem Fall wird das Tiefenprofil der Konzentration D der implantierten Ionen vorteilhaft auf beiden Seiten der Trennschicht 4 durch eine Verminderung der Diffusion der Ionen in die angrenzenden Schichten und das Aufwachssubstrat verschmälert. Selbstverständlich kann die anhand der Figuren 3 bis 5 erläuterte Verwendung von Diffusionsbarriereschichten oberhalb und/oder unterhalb der Trennschicht 4 mit den im Zusammenhang mit den Figuren 1 und 2 beschriebenen vorteilhaften Ausgestaltungen der Trennschicht 4 kombiniert werden.

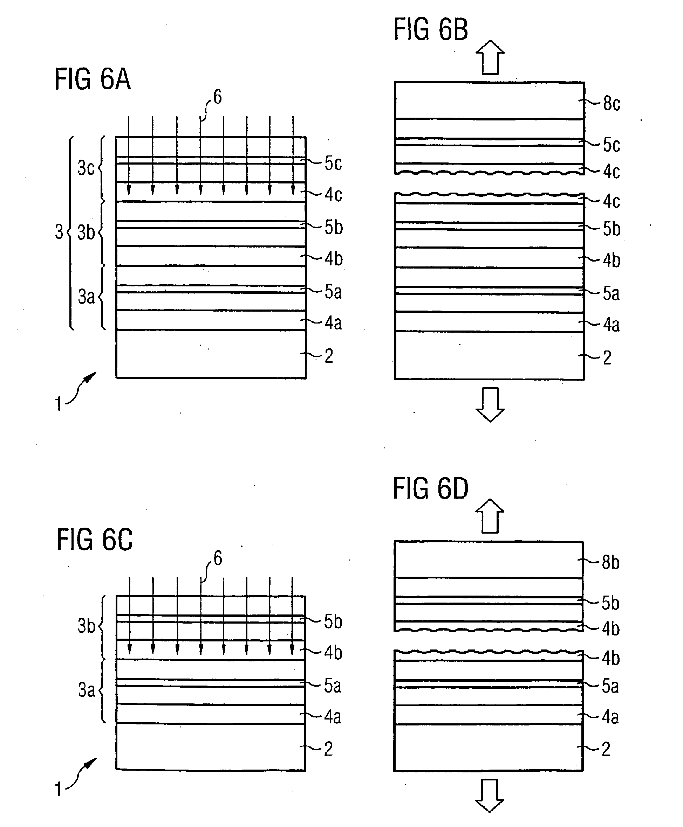

Eine weitere vorteilhafte Ausgestaltung des Verfahrens gemäß der Erfindung wird im Folgenden anhand der in den Figuren 6A bis 6F schematisch dargestellten Zwischenschritte erläutert.

Der in Figur 6A dargestellte Halbleiterwafer 1 enthält eine epitaktisch auf einem Aufwachssubstrat 2 aufgewachsene Halbleiterschichtenfolge 3 aus drei übereinander angeordneten Teilschichtenfolgen 3a, 3b, 3c. Anstelle von drei Teilschichtenfolgen kann die Halbleiterschichtenfolge 3 auch eine beliebige andere Anzahl von übereinander angeordneten Teilschichtenfolgen aufweisen. Jede der Teilschichtenfolgen 3a, 3b, 3c enthält eine Trennschicht 4a, 4b, 4c und jeweils mindestens eine der Trennschicht in Wachstumsrichtung nachfolgende funktionelle Halbleiterschicht 5a, 5b, 5c.

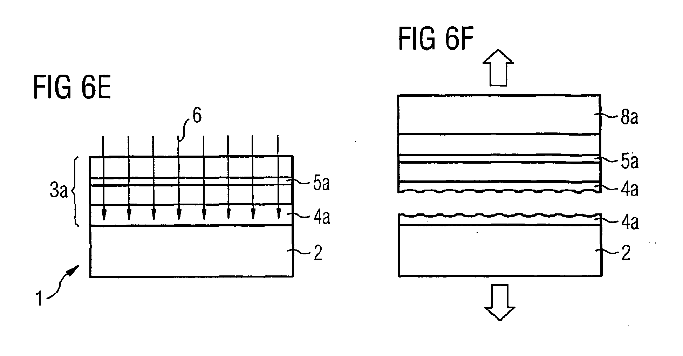

Wie in den Figuren 6A, 6B, 6C, 6D, 6E und 6F schematisch dargestellt, werden die Teilschichtenfolgen 3a, 3b und 3c durch eine Wiederholung des Verfahrensschritts der Ionenimplantation und des nachfolgenden Zertrennens des Halbleiterwafers entlang der jeweiligen Trennschichten 4a, 4b, 4c nacheinander von dem Halbleiterwafer 1 abgetrennt.

Die Ionenimplantation erfolgt dabei jeweils in die oberste der noch auf dem Halbleiterwafer 1 vorhandenen Trennschichten. Beispielsweise ist in Fig. 6A die Ionenimplantation in die anfangs oberste Trennschicht 4c, die in der Teilschichtenfolge 3c enthalten ist, dargestellt. Fig. 6B stellt das Zertrennen des Halbleiterwafers entlang der obersten Trennschicht 4c dar. Vor dem Verfahrensschritt des Abtrennens ist die Halbleiterschichtenfolge 3 an der von dem Aufwachssubstrat 2 abgewandten Oberfläche mit einem Trägersubstrat 8c verbunden worden. Die nach dem Verfahrensschritt des Abtrennens auf den auf der Teilschichtenfolge 3b und/oder auf der von dem Trägersubstrat 8c abgewandten Seite der abgetrennten Teilschichtenfolge 3c verbleibenden Reste der durchtrennten Trennschicht 4c werden vorteilhaft mit einem Ätz- oder Polierprozess geglättet oder entfernt.

Anschließend werden die Verfahrensschritte der Ionenimplantation und des Abtrennens entsprechend der Anzahl der Teilschichtenfolgen wiederholt. Zum Beispiel ist in Fig. 6C der Verfahrensschritt in der Ionenimplantation in die Trennschicht 4b dargestellt, die nach dem in Fig. 6B dargestellten Abtrennen der oberen Teilschichtenfolge 3c die oberste Trennschicht ist.

Fig. 6D zeigt das Zertrennen des Halbleiterwafers entlang der Trennschicht 4b, wobei die Teilschichtenfolge 3b auf ein Trägersubstrat 8b übertragen wird.

Mittels einer weiteren, in den Figuren 6E und 6F dargestellten Wiederholung der Ionenimplantation und des Zertrennens des Halbleiterwafers entlang der Trennschicht 4a wird auch die Teilschichtenfolge 3a auf ein Trägersubstrat 8a übertragen. Nach dem sukzessiven Abtrennen der mehreren Teilschichtenfolgen 3a, 3b, 3c werden eventuell vorhandene Reste der Trennschicht 4a von dem Aufwachssubstrat 2 entfernt. Das Aufwachssubstrat 2 kann somit vorteilhaft erneut zum Aufwachsen einer Halbleiterschichtenfolge 3 aus mehreren Teilschichtenfolgen 3a, 3b, 3c verwendet werden.

Die Erfindung ist nicht durch die Beschreibung anhand der Ausführungsbeispiele beschränkt.

## Patentansprüche

1. Verfahren zum lateralen Zertrennen eines Halbleiterwafers (1), der ein Aufwachssubstrat (2) und eine Halbleiterschichtenfolge (3) enthält, mit den Verfahrensschritten:
- Bereitstellen des Aufwachssubstrats (2),
- Epitaktisches Aufwachsen der Halbleiterschichtenfolge (3) auf das Aufwachssubstrat (2), wobei die Halbleiterschichtenfolge (3) eine als Trennschicht (4) vorgesehene Schicht und mindestens eine der Trennschicht (4) in Wachstumsrichtung nachfolgende funktionelle Halbleiterschicht (5) umfasst,
- Implantation von Ionen durch die funktionelle Halbleiterschicht (5) hindurch in die Trennschicht (4), und
- Zertrennen des Halbleiterwafers (1), wobei ein das Aufwachssubstrat (2) enthaltender Teil (1a) des Halbleiterwafers (1) entlang der Trennschicht (4) abgetrennt wird.

2. Verfahren nach Anspruch 1,
**dadurch gekennzeichnet, dass**
das Zertrennen mittels einer Temperaturbehandlung erfolgt.

3. Verfahren nach Anspruch 1 oder 2,
**dadurch gekennzeichnet, dass**
die Temperaturbehandlung bei einer Temperatur im Bereich von 300 °C bis 1200 °C erfolgt.

4. Verfahren nach einem der vorhergehenden Ansprüche,
**dadurch gekennzeichnet, dass**
das Aufwachssubstrat (2) ein GaN-Substrat oder ein AlN-Substrat ist.

5. Verfahren nach einem der vorhergehenden Ansprüche,
**dadurch gekennzeichnet, dass**
die Halbleiterschichtenfolge (3) auf einem Nitridverbindungshalbleiter basiert.

6. Verfahren nach einem der vorhergehenden Ansprüche,
**dadurch gekennzeichnet, dass**
bei der Ionenimplantation Wasserstoffionen, Heliumionen, Wasserstoffionen und Heliumionen, oder Wasserstoffionen und Borionen implantiert werden.

7. Verfahren nach einem der vorhergehenden Ansprüche,
**dadurch gekennzeichnet, dass**
nach der Ionenimplantation ein thermisches Ausheilen der Halbleiterschichtenfolge (3) erfolgt.

8. Verfahren nach einem der vorhergehenden Ansprüche,
**dadurch gekennzeichnet, dass**
die Trennschicht (4) zumindest ein Element enthält, das eine größere Kernladungszahl als Gallium aufweist.

9. Verfahren nach Anspruch 8,
**dadurch gekennzeichnet, dass**
die Trennschicht (4) Indium enthält.

10. Verfahren nach einem der vorhergehenden Ansprüche,
**dadurch gekennzeichnet, dass**
die Halbleiterschichtenfolge (3) mindestens eine der Trennschicht (4) benachbarte Diffusionsbarriereschicht (10, 11) für die implantierten Ionen enthält.

11. Verfahren nach Anspruch 10,
**dadurch gekennzeichnet, dass**
die Diffusionsbarriereschicht (10, 11) eine mit Zn, Fe oder Si dotierte Nitridverbindungshalbleiterschicht ist.

12. Verfahren nach Anspruch 10 oder 11,
**dadurch gekennzeichnet, dass**
die Halbleiterschichtenfolge (3) beidseits der Trennschicht (4) Diffusionsbarriereschichten (10, 11) für die implantierten Ionen enthält.

13. Verfahren nach einem der vorhergehenden Ansprüche,
**dadurch gekennzeichnet, dass**
die Trennschicht (4) eine tensil verspannte Schicht ist.

14. Verfahren nach Anspruch 13,
**dadurch gekennzeichnet, dass**
die tensil verspannte Trennschicht (4) eine Nitridverbindungshalbleiterschicht ist, die Aluminium enthält.

15. Verfahren nach Anspruch 13 oder 14,
**dadurch gekennzeichnet, dass**
die tensil verspannte Trennschicht (4) eine Si-dotierte Nitridverbindungshalbleiterschicht ist.

16. Verfahren nach einem der vorhergehenden Ansprüche,
**dadurch gekennzeichnet, dass**
die Trennschicht (4) eine durch laterales epitaktisches Überwachsen (ELOG) hergestellte Halbleiterschicht ist.

17. Verfahren nach einem der vorhergehenden Ansprüche,
**dadurch gekennzeichnet, dass**
die Trennschicht (4) aus einem Halbleitermaterial gebildet ist, in dem die implantierten Ionen einen größeren Diffusionskoeffizienten als in einer an die Trennschicht (4) angrenzenden Schicht aufweisen.

18. Verfahren nach Anspruch 17,
**dadurch gekennzeichnet, dass**
die Trennschicht (4) eine p-dotierte Nitridverbindungshalbleiterschicht ist.

19. Verfahren nach einem der vorhergehenden Ansprüche,
**dadurch gekennzeichnet, dass**
der Halbleiterwafer (1) vor dem Zertrennen an einer von dem Aufwachssubstrat (2) abgewandten Oberfläche mit einem Trägersubstrat (8) verbunden wird.

20. Verfahren nach einem der vorhergehenden Ansprüche,
**dadurch gekennzeichnet, dass**
die funktionelle Halbleiterschicht (5) eine strahlungsemittierende oder strahlungsdetektierende Schicht ist.

21. Verfahren nach einem der vorhergehenden Ansprüche,
**dadurch gekennzeichnet, dass**
die funktionelle Halbleiterschicht (5) InₓAl_{y}Ga_{1-x-y}N mit 0 ≤ x ≤ 1, 0 ≤ y ≤ 1 und x+y ≤ 1, aufweist.

22. Verfahren nach einem der vorhergehenden Ansprüche,
**dadurch gekennzeichnet, dass**
die Halbleiterschichtenfolge (3) eine Anzahl weiterer Trennschichten (4b, 4c) enthält, welche der Trennschicht (4a) in Wachstumsrichtung nachfolgen, wobei vor dem Verfahrensschritt der Ionenimplantation in die Trennschicht (4a) folgende Verfahrenschritte durchgeführt werden:
a) Ionenimplantation in eine obere Trennschicht (4c), wobei die obere Trennschicht (4c) diejenige der weiteren Trennschichten (4b, 4c) ist, welche den größten Abstand vom Aufwachssubstrat (2) aufweist,
b) Zertrennen des Halbleiterwafers entlang der oberen Trennschicht (4c), und
c) gegebenenfalls wiederholte Durchführung der Verfahrensschritte a) und b), wobei die Anzahl der Wiederholungen gleich der Anzahl der weiteren Trennschichten (4b, 4c) ist.

## Claims

1. A method for laterally dividing a semiconductor wafer (1) containing a growth substrate (2) and a semiconductor layer sequence (3), comprising the method steps of:
- providing the growth substrate (2),
- epitaxially growing the semiconductor layer sequence (3) onto the growth substrate (2), the semiconductor layer sequence (3) comprising a layer provided as a separating layer (4) and at least one functional semiconductor layer (5) which succeeds the separating layer (4) in the growth direction,
- implanting ions through the functional semiconductor layer (5) into the separating layer (4), and
- dividing the semiconductor wafer (1), a part (1a) of the semiconductor wafer (1) which contains the growth substrate (2) being separated along the separating layer (4).

2. The method as claimed in claim 1,
wherein
dividing is effected by means of a thermal treatment.

3. The method as claimed in claim 1 or 2,
wherein
the thermal treatment is effected at a temperature within the range of 300°C to 1200°C.

4. The method as claimed in one of the preceding claims,
wherein
the growth substrate (2) is a GaN substrate or an AlN substrate.

5. The method as claimed in one of the preceding claims,
wherein
the semiconductor layer sequence (3) is based on a nitride compound semiconductor material.

6. The method as claimed in one of the preceding claims,
wherein
hydrogen ions, helium ions, hydrogen ions and helium ions, or hydrogen ions and boron ions are implanted during the ion implantation.

7. The method as claimed in one of the preceding claims,
wherein
thermal annealing of the semiconductor layer sequence (3) is effected after the ion implantation.

8. The method as claimed in one of the preceding claims,
wherein
the separating layer (4) contains at least one element which has a higher atomic number than gallium.

9. The method as claimed in claim 8,
wherein
the separating layer (4) contains indium.

10. The method as claimed in one of the preceding claims,
wherein
the semiconductor layer sequence (3) contains at least one diffusion barrier layer (10, 11)-adjacent to the separating layer (4) - for the implanted ions.

11. The method as claimed in claim 10,
wherein
the diffusion barrier layer (10, 11) is a nitride compound semiconductor layer doped with Zn, Fe or Si.

12. The method as claimed in claim 10 or 11,
wherein
the semiconductor layer sequence (3) contains diffusion barrier layers (10, 11) for the implanted ions on both sides of the separating layer (4).

13. The method as claimed in one of the preceding claims,
wherein
the separating layer (4) is a tensile-stressed layer.

14. The method as claimed in claim 13,
wherein
the tensile-stressed separating layer (4) is a nitride compound semiconductor layer containing aluminum.

15. The method as claimed in claim 13 or 14,
wherein
the tensile-stressed separating layer (4) is an Si-doped nitride compound semiconductor layer.

16. The method as claimed in one of the preceding claims,
wherein
the separating layer (4) is a semiconductor layer produced by lateral epitaxial overgrowth (ELOG).

17. The method as claimed in one of the preceding claims,
wherein
the separating layer (4) is formed from a semiconductor material in which the implanted ions have a greater diffusion coefficient than in a layer adjoining the separating layer (4).

18. The method as claimed in claim 17,
wherein
the separating layer (4) is a p-doped nitride compound semiconductor layer.

19. The method as claimed in one of the preceding claims,
wherein
the semiconductor wafer (1) is connected to a carrier substrate (8) prior to dividing at a surface remote from the growth substrate (2).

20. The method as claimed in one of the preceding claims,
wherein
the functional semiconductor layer (5) is a radiation-emitting layer or a radiation-detecting layer.

21. The method as claimed in one of the preceding claims,
wherein
the functional semiconductor layer (5) has InₓAl_{y}Ga_{1-x-y}N where 0 ≤ × ≤1, 0 ≤ y ≤ 1 and ×+y ≤ 1.

22. The method as claimed in one of the preceding claims,
wherein
the semiconductor layer sequence (3) contains a number of further separating layers (4b, 4c) which succeed the separating layer (4a) in the growth direction, the following method steps being carried out prior to the method step of ion implantation into the separating layer (4a):
a) ion implantation into an upper separating layer (4c), the upper separating layer (4c) being that one of the further separating layers (4b, 4c) which is at the greatest distance from the growth substrate (2),
b) dividing the semiconductor wafer along the upper separating layer (4c), and
c) if appropriate repeatedly carrying out method steps a) and b), the number of repetitions being equal to the number of further separating layers (4b, 4c).

## Revendications

1. Procédé destiné à la séparation latérale d'une galette de semi-conducteur (1) qui comprend un substrat de croissance (2) et une suite de couches de semi-conducteur (3), comprenant les étapes de procédé :
- préparation du substrat de croissance (2),
- croissance épitactique de la suite de couches de semi-conducteur (3) sur le substrat de croissance (2), la suite de couches de semi-conducteur (3) comprenant une couche ménagée en tant que couche de séparation (4) et au moins une couche fonctionnelle de semi-conducteur (5) subséquente à la couche de séparation (4) dans la direction de croissance,
- implantation d'ions dans la couche de séparation (4) à travers la couche fonctionnelle de semi-conducteur (5), et
- séparation de la galette de semi-conducteur (1), une partie (1a), contenant le substrat de croissance (2), de la galette de semi-conducteur (1) étant séparée le long de la couche de séparation (4).

2. Procédé selon la revendication 1,
**caractérisé en ce que**
la séparation est réalisée au moyen d'un traitement thermique.

3. Procédé selon la revendication 1 ou 2,
**caractérisé en ce que**
le traitement thermique est réalisé à une température située dans la plage de 300 °C à 1200 °C.

4. Procédé selon l'une quelconque des revendications précédentes,
**caractérisé en ce que**
le substrat de croissance (2) est un substrat GaN ou un substrat AlN.

5. Procédé selon l'une quelconque des revendications précédentes,
**caractérisé en ce que**
la suite de couches de semi-conducteur (3) est basée sur un semi-conducteur à liaison nitrure.

6. Procédé selon l'une quelconque des revendications précédentes,
**caractérisé en ce que**
lors de l'implantation d'ions, on implante des ions d'hydrogène, des ions d'hélium, des ions d'hydrogène et des ions d'hélium ou des ions d'hydrogène et des ions boriques.

7. Procédé selon l'une quelconque des revendications précédentes,
**caractérisé en ce qu'**
après l'implantation d'ions, on réalise une régénération thermique de la suite de couches de semi-conducteur (3).

8. Procédé selon l'une quelconque des revendications précédentes,
**caractérisé en ce que**
la couche de séparation (4) contient au moins un élément présentant un nombre atomique supérieur au gallium.

9. Procédé selon la revendication 8,
**caractérisé en ce que**
la couche de séparation (4) contient de l'indium.

10. Procédé selon l'une quelconque des revendications précédentes,
**caractérisé en ce que**
la suite de couches de semi-conducteur (3) contient au moins une couche barrière à la diffusion (10, 11), adjacente à la couche de séparation (4), pour les ions implantés.

11. Procédé selon la revendication 10,
**caractérisé en ce que**
la couche barrière à la diffusion (10, 11) est une couche de semi-conducteur à liaison nitrure dopée avec du zinc, du fer ou du silicium.

12. Procédé selon la revendication 10 ou 11,
**caractérisé en ce que**
la suite de couches de semi-conducteur (3) contient de chaque côté de la couche de séparation (4) des couches barrières à la diffusion (10, 11) pour les ions implantés.

13. Procédé selon l'une quelconque des revendications précédentes,
**caractérisé en ce que**
la couche de séparation (4) est une couche contrainte de traction.

14. Procédé selon la revendication 13,
**caractérisé en ce que**
la couche de séparation (4) contrainte de traction est une couche de semi-conducteur à liaison nitrure, qui contient de l'aluminium.

15. Procédé selon la revendication 13 ou 14,
**caractérisé en ce que**
la couche de séparation (4) contrainte de manière flexible est une couche de semi-conducteur à liaison nitrure dopée de silicium.

16. Procédé selon l'une quelconque des revendications précédentes,
**caractérisé en ce que**
la couche de séparation (4) est une couche de semi-conducteur fabriquée par surcroissance épitactique latérale (ELOG).

17. Procédé selon l'une quelconque des revendications précédentes,
**caractérisé en ce que**
la couche de séparation (4) est formée par un matériau de semi-conducteur, dans lequel les ions implantés présentent un coefficient de diffusion plus grand que dans une couche adjacente à la couche de séparation (4).

18. Procédé selon la revendication 17,
**caractérisé en ce que**
la couche de séparation (4) est une couche de semi-conducteur à liaison nitrure dotée p.

19. Procédé selon l'une quelconque des revendications précédentes,
**caractérisé en ce que**
la galette de semi-conducteur (1), avant la séparation, est reliée à un substrat porteur (8) sur une surface détournée du substrat de croissance (2).

20. Procédé selon l'une quelconque des revendications précédentes,
**caractérisé en ce que**
la couche fonctionnelle de semi-conducteur (5) est une couche émettant un rayonnement ou une couche détectant un rayonnement.

21. Procédé selon l'une quelconque des revendications précédentes,
**caractérisé en ce que**
la couche fonctionnelle de semi-conducteur (5) présente InₓAl_{y}Ga_{1-x-y}N avec
0 ≤ x ≤ 1, 0 ≤ y ≤ 1 et ×+y ≤ 1.

22. Procédé selon l'une quelconque des revendications précédentes,
**caractérisé en ce que**
la suite de couches de semi-conducteur (3) contient un nombre de couches de séparation supplémentaires (4b, 4c), lesquelles succèdent à la couche de séparation (4a) dans la direction de croissance, les étapes de procédés suivantes étant réalisées avant l'étape de procédé d'implantation d'ions dans la couche de séparation (4a) :
a) implantation d'ions dans une couche de séparation supérieure (4c), la couche de séparation supérieure (4c) étant celle des couches de séparation supplémentaires (4b, 4c) qui présente le plus grand écart par rapport au substrat de croissance (2),
b) séparation de la galette de semi-conducteur le long de la couche de séparation supérieure (4c), et
c) le cas échéant, exécution répétée des étapes de procédés a) et b), le nombre de répétitions étant égal au nombre de couches de séparation supplémentaires (4b, 4c).
